# EUROPEAN PATENT APPLICATION

(11) **EP 4 694 608 A1**
(43) Date of publication of application: **11.02.2026**
(21) Application number: 24905145.9
(22) Date of filing: 10.10.2024
(51) Int. Cl.: H10B 12/00

(54) **METHOD FOR PREPARING SEMICONDUCTOR STRUCTURE AND SEMICONDUCTOR STRUCTURE**

(30) Priority: 27.06.2024 CN 202410853869
(71) Applicant: CXMT Corporation, Hefei, Anhui 230601 (CN)
(72) Inventor: ZHAO, Zhipeng, Hefei, Anhui 230601 (CN); WANG, Xiaoling, Hefei, Anhui 230601 (CN); LUO, Qiong, Hefei, Anhui 230601 (CN)
(74) Representative: Gulde & Partner
(86) International application number: PCT/CN2024/123951
(87) International publication number: WO 2026/000701

(57) **Abstract**

A method for manufacturing a semiconductor structure and a semiconductor structure are provided. The method includes: providing a base substrate and forming isolation structures inside the base substrate, where the isolation structures are disposed apart from each other; forming a stacked structure on the base substrate, where the stacked structure is formed by alternately stacking first layers and second layers in a third direction; forming stack openings, where the stack openings pass through the stacked structure along the third direction; forming first base substrate openings, where the first base substrate openings are respectively located below the stack openings and extend into the base substrate, one of the stack openings and one of the first base substrate openings compose one of first openings, an orthographic projection of each of the first openings on the base substrate is located within an orthographic projection of one of the isolation structures on the base substrate, and/or the orthographic projection of the first opening on the base substrate is located between adjacent isolation structures; removing parts of the second layers to form second openings, and etching the first base substrate openings to form base substrate openings, where one of the stack openings, one of the base substrate openings, and some of the second openings together compose one of combined openings; and forming capacitor structures in the combined openings, where the capacitor structures extend along a first direction and are disposed apart from each other in both a second direction and the third direction.

## Description

### CROSS-REFERENCE

The present disclosure claims priority to Chinese Patent Application No. 202410853869.4 filed on June 27, 2024 and entitled "METHOD FOR MANUFACTURING SEMICONDUCTOR STRUCTURE AND SEMICONDUCTOR STRUCTURE", the content of which is incorporated herein by reference in its entirety.

### TECHNICAL FIELD

Embodiments of the present disclosure relate to the field of semiconductors, in particular, to a method for manufacturing a semiconductor structure and a semiconductor structure.

### BACKGROUND

As dynamic random access memories (DRAMs) develop, they are expected to have such performance indicators as high speed, high integration density, and low power consumption. With the miniaturization of structures of semiconductor devices, technical barriers to existing structures are increasingly obvious. Therefore, it is an advantageous way to break the existing technical barriers by developing more novel structures on the basis of the existing structures.

The advent of three-dimensional dynamic random access memories (3D DRAMs) has satisfied the above-mentioned need. However, existing 3D DRAMs require many cycles of etching and cleaning, and the base substrate may be damaged during the etching procedure, affecting the performance and yield of semiconductor structures.

### SUMMARY

Embodiments of the present disclosure provide a method for manufacturing a semiconductor structure and a semiconductor structure, which can at least facilitate the protection of the base substrate and improve the performance and yield of semiconductor memory devices.

According to some embodiments of the present disclosure, in one aspect of the embodiments of the present disclosure, a method for manufacturing a semiconductor structure is provided. The method includes: providing a base substrate, and forming isolation structures inside the base substrate, where the isolation structures are disposed apart from each other;
forming a stacked structure on the base substrate, where the stacked structure is formed by alternately stacking first layers and second layers in a third direction, and the third direction is perpendicular to a surface of the base substrate;
forming stack openings, where the stack openings pass through the stacked structure along the third direction;
forming first base substrate openings, where the first base substrate openings are respectively located below the stack openings and extend into the base substrate, one of the stack openings and one of the first base substrate openings compose one of first openings, an orthographic projection of each of the first openings on the base substrate is located within an orthographic projection of one of the isolation structures on the base substrate, and/or the orthographic projection of the first opening on the base substrate is located between adjacent isolation structures;
removing parts of the second layers to form second openings, and etching the first base substrate openings to form base substrate openings, where one of the stack openings, one of the base substrate openings, and some of the second openings together compose one of combined openings; and
forming capacitor structures in the combined openings, where the capacitor structures extend along a first direction and are disposed apart from each other in both a second direction and the third direction.

In some embodiments, the process of removing parts of the second layers to form the second openings further includes: etching the first base substrate openings to form second base substrate openings, where a size of each of the second base substrate openings along the first direction is greater than a size of each of the first base substrate openings along the first direction; a depth of the second base substrate opening along the third direction is greater than a depth of the first base substrate opening along the third direction, the first direction is parallel to the surface of the base substrate, and the first direction is perpendicular to the third direction.

In some embodiments, one of the stack openings, some of the second openings, and one of the second base substrate openings together compose one of third openings, and the method further includes: forming a first conductive material layer in the third openings, where the first conductive material layer covers exposed surfaces of the third openings; forming a first sacrificial layer, where the first sacrificial layer fills up remaining parts of the third openings; removing parts of the first sacrificial layer to form fourth openings, where remaining parts of the first sacrificial layer are located only in the second openings; and removing parts of the first conductive material layer exposed by the fourth openings, and removing the first sacrificial layer in the second openings, where remaining parts of the first conductive material layer are used as a first conductive layer.

In some embodiments, the process of removing the parts of the first conductive material layer exposed by the fourth openings further includes: etching the second base substrate openings to form third base substrate openings, where a size of each of the third base substrate openings along the first direction is greater than a size of the second base substrate opening along the first direction; a depth of the third base substrate opening along the third direction is greater than a depth of the second base substrate opening along the third direction.

In some embodiments, the process of removing the first sacrificial layer in the second openings further includes: etching the third base substrate openings to form the base substrate openings, where each of the base substrate openings exposes an upper surface of one of the isolation structures, and/or the isolation structures are respectively located on two sides of each of the base substrate openings.

In some embodiments, one of the stack openings, one of the base substrate openings, and some of the second openings together compose one of combined openings, and forming the capacitor structures in the combined openings specifically includes: forming the first conductive layer in the second openings, where the first conductive layer covers only exposed surfaces of the second openings; and forming a dielectric layer on the first conductive layer, and forming a second conductive layer on the dielectric layer, where the second conductive layer fills up remaining parts of the combined openings, and the first conductive layer, the dielectric layer, and the second conductive layer together compose the capacitor structures.

In some embodiments, the isolation structures are respectively located on two sides of the base substrate opening, a bottom spacing is present between a bottom of each of the isolation structures and the surface of the base substrate along the third direction, and the base substrate opening has a fourth spacing along the third direction, where the fourth spacing is not greater than the bottom spacing.

In some embodiments, forming the isolation structures inside the base substrate specifically includes: forming photoresist layers and defining first openings, performing first processing through the first openings to form first initial isolation structures, and performing second processing on the first initial isolation structures to form the isolation structures, where a first spacing is present between a top of each of the isolation structures and the surface of the base substrate.

In some embodiments, forming the isolation structures inside the base substrate specifically includes: etching the base substrate to form first trenches, where the first trenches are disposed apart from each other; and forming the isolation structures in the first trenches, where tops of the isolation structures are flush with the base substrate.

In some embodiments, forming the isolation structures inside the base substrate specifically includes: forming photoresist layers and defining first openings, performing first processing through the first openings to form first initial isolation structures, forming photoresist layers and defining second openings, performing first processing through the second openings to form second initial isolation structures, and performing second processing on the first initial isolation structures and the second initial isolation structures to form first isolation structures and second isolation structures, respectively, where the first isolation structures and the second isolation structures compose the isolation structures, each of the first isolation structures is located at a bottom of one of the first base substrate openings, and each of the second isolation structures is located on a side of one of the first base substrate openings.

In some embodiments, after the second openings are formed, the method further includes: removing parts of the first layers to form first expanded holes, where a size of each of the first expanded holes along the third direction is greater than a size of each of the second openings along the third direction.

In another aspect of the embodiments of the present disclosure, a semiconductor structure is provided. The semiconductor structure includes: a base substrate, where the base substrate is provided inside with isolation structures, and the isolation structures are disposed apart from each other;
a stacked structure disposed on the base substrate, the stacked structure being formed by alternately stacking first layers and second layers in a third direction, and the third direction being perpendicular to a surface of the base substrate;
stack openings passing through the stacked structure along the third direction;
base substrate openings respectively located below the stack openings and extending into the base substrate, a size of each of the base substrate openings along the first direction being greater than a size of each of the stack openings along the first direction, and
each of the isolation structures being located at least on a side of and/or at a bottom of one of the base substrate openings;
second openings formed by removing parts of the second layers, one of the stack openings, one of the base substrate openings, and some of the second openings together composing one of combined openings; and
capacitor structures located in the combined openings, the capacitor structures extending along a first direction and being disposed apart from each other in both a second direction and the third direction.

In some embodiments, the isolation structures are respectively located on two sides of the base substrate opening, and an orthographic projection of the base substrate opening on the base substrate is located between adjacent isolation structures.

In some embodiments, the isolation structure is located at the bottom of the base substrate opening, and an orthographic projection of the base substrate opening on the base substrate is located within an orthographic projection of the isolation structure on the base substrate.

In some embodiments, the isolation structure includes a first isolation structure and second isolation structures, the first isolation structure is located at the bottom of the base substrate opening, and each of the second isolation structures is located on a side of the base substrate opening.

In some embodiments, a first spacing is present between a top of the isolation structure and a top of the base substrate, or the top of the isolation structure is flush with the top of the base substrate.

In some embodiments, a bottom spacing is provided between a bottom of the isolation structure and the surface of the base substrate along the third direction, and the base substrate opening has a fourth spacing along the third direction, where the fourth spacing is not greater than the bottom spacing.

In some embodiments, the base substrate opening exposes the isolation structure, and each of the capacitor structures is located above the isolation structure.

The technical solutions provided in the embodiments of the present disclosure at least have the following advantages: As isolation structures are disposed inside a base substrate and each of the isolation structures at least surrounds a bottom surface and/or a lateral surface of a base substrate opening, electric leakage or a short circuit caused by over-etching of a silicon base substrate is effectively ameliorated during the transverse etching or other types of etching, such that the performance and yield of semiconductor devices can be improved.

### BRIEF DESCRIPTION OF THE DRAWINGS

One or more embodiments are exemplarily illustrated with reference to figures in the corresponding drawings, and these exemplary illustrations are not to be construed as limiting the embodiments. Unless expressly stated otherwise, the figures in the drawings do not constitute a limitation of scale. To more clearly illustrate the technical solutions in the embodiments of the present disclosure or conventional technology, a brief introduction to the drawings required to be used in the embodiments is given hereinafter. It is evident that the drawings described hereinafter are merely some embodiments of the present disclosure. For those of ordinary skill in the art, other drawings may be further obtained based on these drawings without creative effort.
FIG. 1 is a flow block diagram of a method for manufacturing a semiconductor structure provided according to an embodiment of the present disclosure.
FIG. 2A to FIG. 2P are process flow diagrams showing a method for manufacturing a semiconductor structure provided according to an embodiment of the present disclosure.
FIG. 3A to FIG. 3P are process flow diagrams showing a method for manufacturing a semiconductor structure provided according to another embodiment of the present disclosure.
FIG. 4A to FIG. 4O are process flow diagrams showing a method for manufacturing a semiconductor structure provided according to still another embodiment of the present disclosure.
FIG. 5 is a schematic diagram of a semiconductor structure provided according to an embodiment of the present disclosure.
FIG. 6 is a schematic diagram of a semiconductor structure provided according to another embodiment of the present disclosure.
FIG. 7 is a schematic diagram of a semiconductor structure provided according to still another embodiment of the present disclosure.

### DETAILED DESCRIPTION

As can be learned from the background, as the dynamic random access memories (DRAMs) develop, they are expected to have such performance indicators as high speed, high integration density, and low power consumption. With the miniaturization of structures of semiconductor devices, technical barriers to existing structures are increasingly obvious. Therefore, it is an advantageous way to break the existing technical barriers by developing more novel structures on the basis of the existing structures. The advent of three-dimensional dynamic random access memories (3D DRAMs), for example, multilayer horizontal cells (MHCs), has satisfied the above-mentioned need. However, existing 3D DRAMs require many cycles of etching and cleaning, and the base substrate may be damaged during the etching procedure, affecting the performance and yield of semiconductor structures.

Embodiments of the present disclosure provide a method for manufacturing a semiconductor structure and a semiconductor structure. As isolation structures are disposed inside a base substrate and each of the isolation structures at least surrounds a bottom surface and/or a lateral surface of a base substrate opening, electric leakage or a short circuit caused by over-etching of a silicon base substrate is effectively ameliorated during the transverse etching or other types of etching, such that the performance and yield of semiconductor devices can be improved.

The embodiments of the present disclosure will be described in detail below with reference to the drawings. However, those of ordinary skill in the art can understand that, in the embodiments of the present disclosure, numerous technical details are set forth to enable readers to better understand the present disclosure. However, the technical solutions claimed by the present disclosure can also be implemented even without these technical details and the various changes and modifications based on the following embodiments.

The present disclosure is more specifically described in the following paragraphs with reference to the drawings by way of example. Advantages and features of the present disclosure will become apparent from the following description and claims. It should be noted that the drawings are all in a very simplified form and not to precise scale, and are provided only for the purpose of facilitating a convenient and clear description of the embodiments of the present disclosure.

It will be understood that the meaning of "on", "above", and "over" in the present disclosure should be interpreted in the broadest manner such that "on" not only includes the meaning of "on" something with no intermediate feature or layer therebetween (for example, directly on something) but also includes the meaning of "on" something with an intermediate feature or a layer therebetween.

In the embodiments of the present disclosure, the terms "first", "second", "third", and the like are used for distinguishing similar objects and are not necessarily used for describing a particular order or sequence.

In the embodiments of the present disclosure, the term "layer" refers to a material portion that includes a region having a thickness. A layer may extend over the entirety of the underlying or overlying structure or may have an extent that is less than the extent of the underlying or overlying structure. Furthermore, a layer may be a region of a homogeneous or inhomogeneous continuous structure having a thickness less than the thickness of a continuous structure. For example, a layer may be located between a top surface and a bottom surface of a continuous structure, or a layer may be located between any pair of horizontal planes at the top surface and the bottom surface of the continuous structure. A layer may extend horizontally, vertically, and/or along inclined surfaces. A layer may include a plurality of sub-layers.

It should be noted that unless conflicting, the technical solutions described in the embodiments of the present disclosure may be arbitrarily combined.

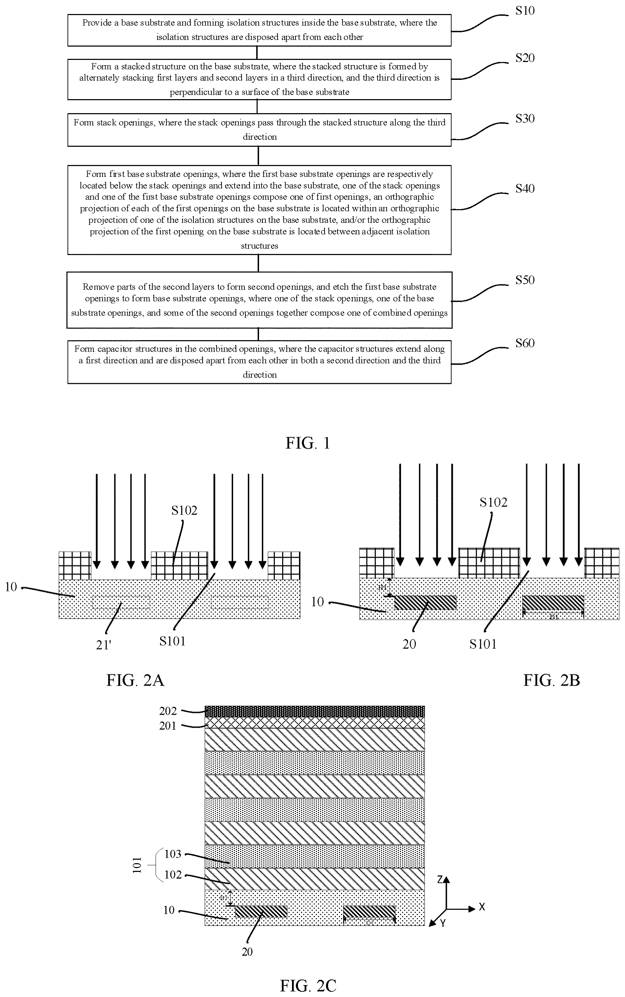

FIG. 1 is a flow block diagram of a method for manufacturing a semiconductor structure provided according to an embodiment of the present disclosure.

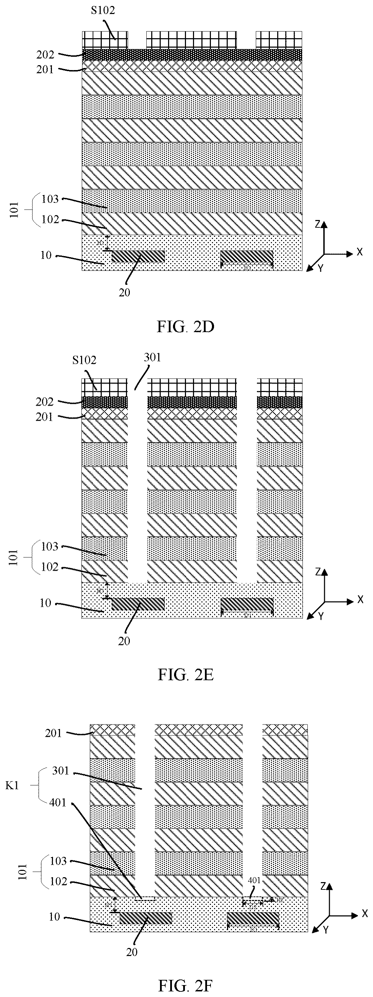

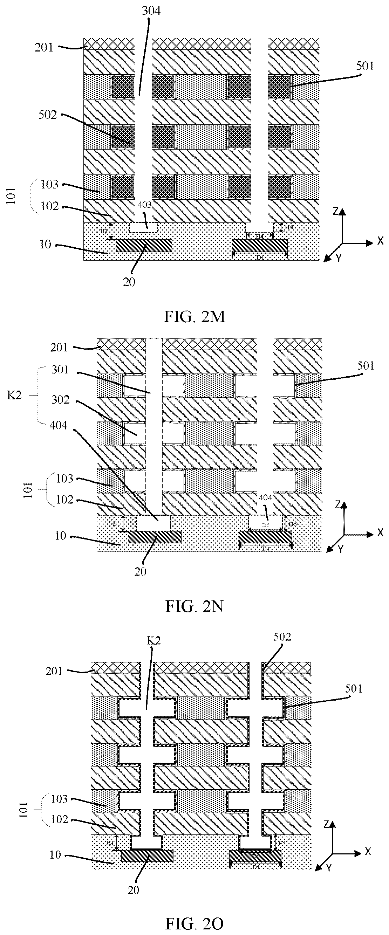

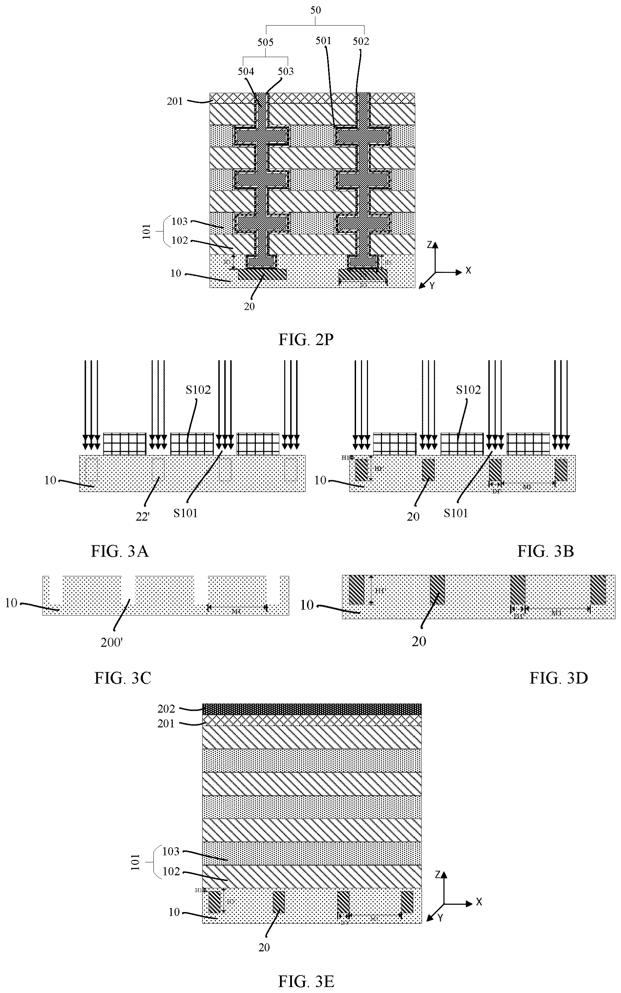

FIG. 2A to FIG. 2P are process flow diagrams showing a method for manufacturing a semiconductor structure provided according to an embodiment of the present disclosure.

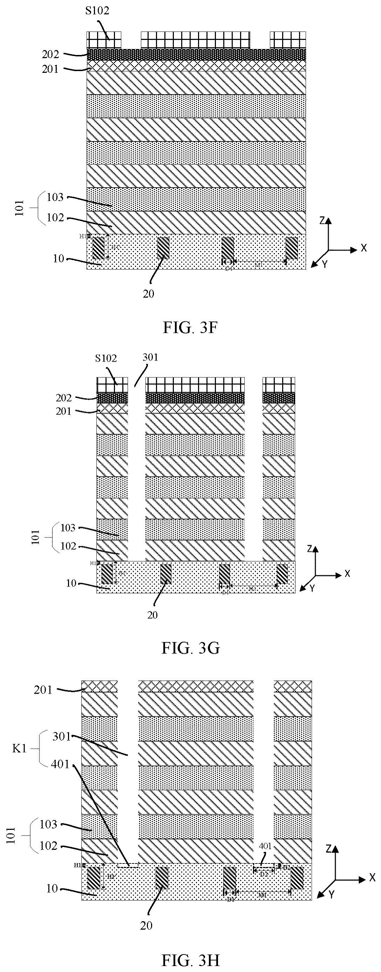

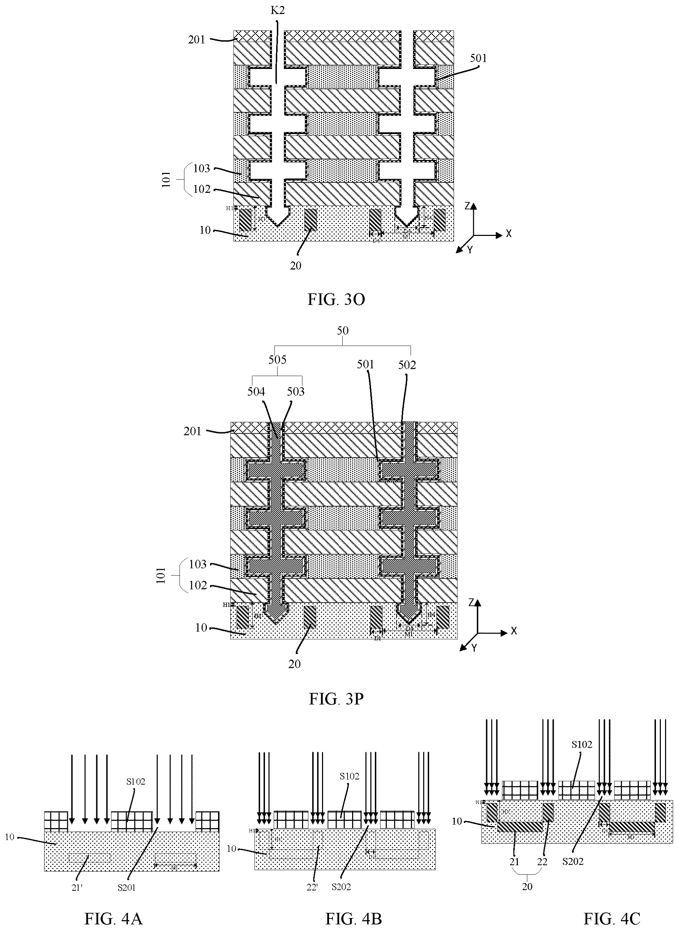

FIG. 3A to FIG. 3P are process flow diagrams showing a method for manufacturing a semiconductor structure provided according to another embodiment of the present disclosure.

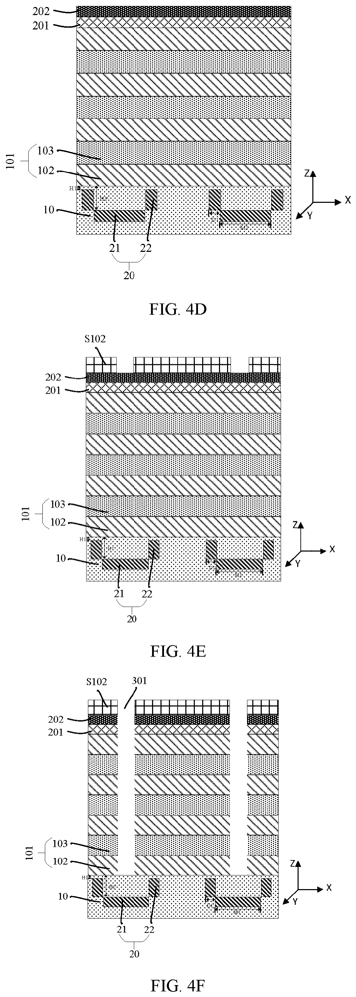

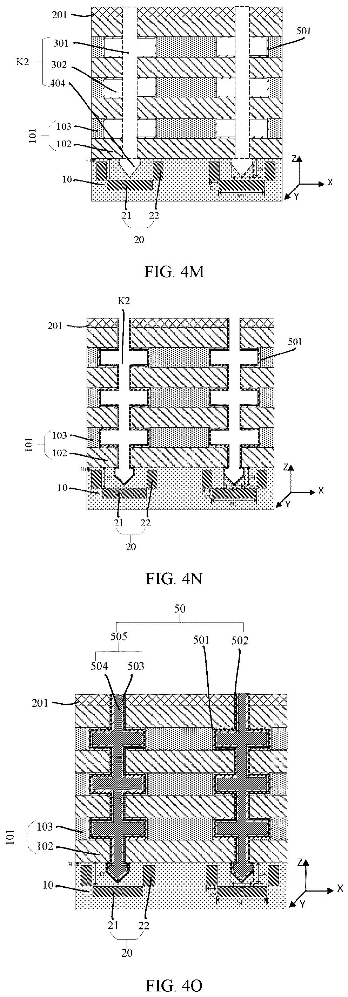

FIG. 4A to FIG. 4O are process flow diagrams showing a method for manufacturing a semiconductor structure provided according to still another embodiment of the present disclosure.

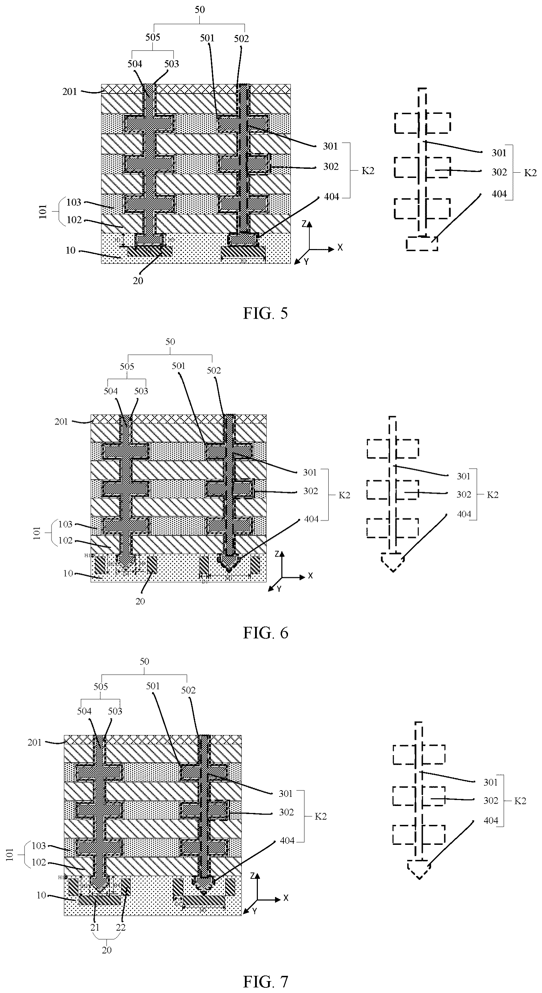

FIG. 5 is a schematic diagram of a semiconductor structure provided according to an embodiment of the present disclosure.

FIG. 6 is a schematic diagram of a semiconductor structure provided according to another embodiment of the present disclosure.

FIG. 7 is a schematic diagram of a semiconductor structure provided according to still another embodiment of the present disclosure.

As shown in FIG. 1, the manufacturing method at least includes the following steps: S 10, providing a base substrate and forming isolation structures inside the base substrate, where the isolation structures are disposed apart from each other; S20, forming a stacked structure on the base substrate, where the stacked structure is formed by alternately stacking first layers and second layers in a third direction, where the third direction is perpendicular to a surface of the base substrate; S30, forming stack openings, where the stack openings pass through the stacked structure along the third direction; S40, forming first base substrate openings, where the first base substrate openings are respectively located below the stack openings and extend into the base substrate, one of the stack openings and one of the first base substrate openings compose one of first openings, an orthographic projection of each of the first openings on the base substrate is located within an orthographic projection of one of the isolation structures on the base substrate, and/or the orthographic projection of the first opening on the base substrate is located between adjacent isolation structures; S50, removing parts of the second layers to form second openings, and etching the first base substrate openings to form base substrate openings, where one of the stack openings, one of the base substrate openings, and some of the second openings together compose one of combined openings; and S60, forming capacitor structures in the combined openings, where the capacitor structures extend along a first direction and are disposed apart from each other in both a second direction and the third direction.

The embodiments of the present disclosure are described in more detail below with reference to the drawings.

Referring to FIG. 1 and FIGS. 2A-2B, a base substrate 10 is provided. Photoresist layers S 102 are formed on the base substrate 10, and first openings S 101 are provided between the photoresist layers S102. First processing is performed on the base substrate 10 through the first openings S101 to form first initial isolation structures 21' inside the base substrate 10, and then second processing is performed on the first initial isolation structures 21' to form isolation structures 20. A first spacing H1 is present between the top of the isolation structure 20 and the surface of the base substrate, the length of the isolation structure 20 along a first direction X is a first length D1, a plurality of isolation structures 20 are disposed apart from each other, the first direction X refers to the direction in which the isolation structure 20 extends, and the first direction X is parallel to the surface of the base substrate 10. The first processing may be plasma implantation (arrows in the figures represent the plasma implantation). The first initial isolation structures 21' having different depths may be obtained by controlling the energy of the plasma implantation, the first initial isolation structures 21' having different concentrations may be obtained by controlling the dose of the plasma implantation, and the first initial isolation structures 21' at different positions may be obtained by controlling the angle of the plasma implantation; the required first initial isolation structures 21' may be obtained by controlling the energy, dose, angle, and the like of the plasma implantation based on process requirements, and in an embodiment, the element for ion implantation may be oxygen atoms. The second processing may be high-temperature annealing. Specifically, in an embodiment, the element oxygen for the ion implantation reacts with a silicon base substrate through the high-temperature annealing to form the isolation structures 20, and the material of the isolation structures 20 may be silicon oxide. Silicon oxide is merely an example for description herein. The material of the isolation structures 20 may be silicon nitride, silicon oxynitride, or the like in other embodiments. The material of the base substrate may be silicon (Si), germanium (Ge), silicon germanium (GeSi), or silicon carbide (SiC), or may be silicon-on-insulator (SOI) or germanium-on-insulator (GOI), or may also be another material, for example, a group III-V compound, for example, gallium arsenide. The material of the base substrate in this embodiment is silicon.

Referring to FIG. 1 and FIG. 2C, a stacked structure 101 is formed on the base substrate 10, and the stacked structure 101 is formed by alternately stacking first layers 102 and second layers 103 in a third direction Z; the third direction Z is perpendicular to the surface of the base substrate. An etching barrier layer 201 and a hard mask layer 202 are provided on the stacked structure 101. The etching barrier layer 201 is located on the stacked structure 101, the hard mask layer 202 is located on the etching barrier layer 201, and the etching barrier layer 201 and the hard mask layer 202 provide protection when stack openings and base substrate openings are formed subsequently by etching to prevent the stacked structure 101 from being damaged.

Referring to FIG. 1 and FIGS. 2D-2E, stack openings 301 are formed. The stack openings 301 pass through the stacked structure 101 along the third direction Z and stop at the upper surface of the base substrate 10. Before the stack openings 301 are formed, the method further includes: forming the photoresist layers S102 on the stacked structure 101. Openings are provided between the photoresist layers S102, and the stacked structure 101 is etched through the openings to form the stack openings 301.

Referring to FIG. 1 and FIG. 2F, first base substrate openings 401 are formed. The first base substrate openings 401 are respectively located below the stack openings 301 and extend into the base substrate 10, and the lengths of the first base substrate opening 401 and the stack opening 301 along the first direction X are the same and are all the second length D2; the second length D2 is less than the first length D1, and the depth of the first base substrate opening 401's extending into the base substrate 10 is a second spacing H2. The stack opening 301 and the first base substrate opening 401 compose a first opening K1, the orthographic projection of the first opening K1 on the base substrate 10 is located within the orthographic projection of the isolation structure 20 on the base substrate 10, that is, the second length D2 of the first opening K1 is less than the first length D1 of the isolation structure 20. The orthographic projection of the first opening K1 on the base substrate 10 may be in the middle of the isolation structure 20 or may deviate from the middle of the isolation structure 20, and being in the middle means that the central axis of the first opening K1 and the central axis of the isolation structure 20 coincide, while the orthographic projection of the first opening K1 within the isolation structure 20 cannot deviate to be beyond the isolation structure 20. The process of forming the first base substrate openings 401 further includes removing the hard mask layer 202 and the photoresist layers S102 at the top of the stacked structure 101.

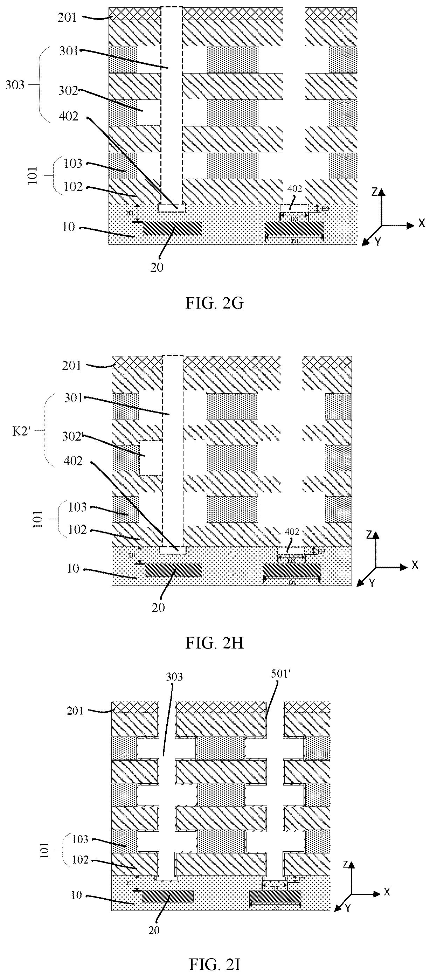

Referring to FIG. 1 and FIG. 2G, parts of the second layers 103 are removed to form second openings 302. The process of removing the parts of the second layers 103 by transverse etching to form the second openings 302 further includes etching the first base substrate openings 401 to form second base substrate openings 402. The length of the second base substrate opening 402 along the first direction X is a third length D3, the length of the first base substrate opening 401 along the first direction X is the second length D2, and the third length D3 is greater than the second length D2. The depth of the second base substrate opening 402's extending into the base substrate 10 along the third direction Z is a third spacing H3, the depth of the first base substrate opening 401's extending into the base substrate 10 along the third direction Z is the second spacing H2, and the third spacing H3 is greater than the second spacing H2. The first direction X is parallel to the surface of the base substrate 10, and the third direction Z is perpendicular to the surface of the base substrate 10. The stack opening 301, the second opening 302, and the second base substrate opening 402 together compose a third opening 303, and the base substrate 10 is over-etched in the process of forming the second openings 302 by transverse etching. FIG. 2G shows only that the depth of the second base substrate opening 402 along the third direction does not expose the isolation structure 20, that is, the third spacing H3 is less than the first spacing H1, but in other embodiments, the depth of the second base substrate opening 402 along the third direction may expose the isolation structure 20, that is, the third spacing H3 is equal to the first spacing H1. The isolation structure 20 can allow the over-etching of the base substrate 10 to stop at the upper surface of the isolation structure 20 and thereby prevent the base substrate 10 from being further damaged.

Referring to FIG. 1 and FIG. 2H, after the second openings 302 are formed, the method further includes removing parts of the first layers 102 along the third direction Z to form first expanded holes 302'. The size of the first expanded hole 302' along the third direction Z is greater than the size of the second opening 302 along the third direction Z, and the first expanded hole 302' can provide a larger window for the formation of the capacitor structure subsequently. The stack opening 301, the first expanded hole 302', and the second base substrate opening 402 together compose an expanded third opening K2'. In the subsequent process of this embodiment, only the third openings 303 are taken as an example. A first conductive material layer is formed in the third openings 303; in other embodiments, a first conductive material layer may be formed in the expanded third opening K2'. That is, the expanded third opening K2' is an optimization of the third opening 303, and the subsequent process performed in the third opening 303 is also applicable to the expanded third opening K2'. In this embodiment, the subsequent process is performed by taking only the third opening 303 as an example, and the subsequent process is also applicable to the expanded third opening K2'.

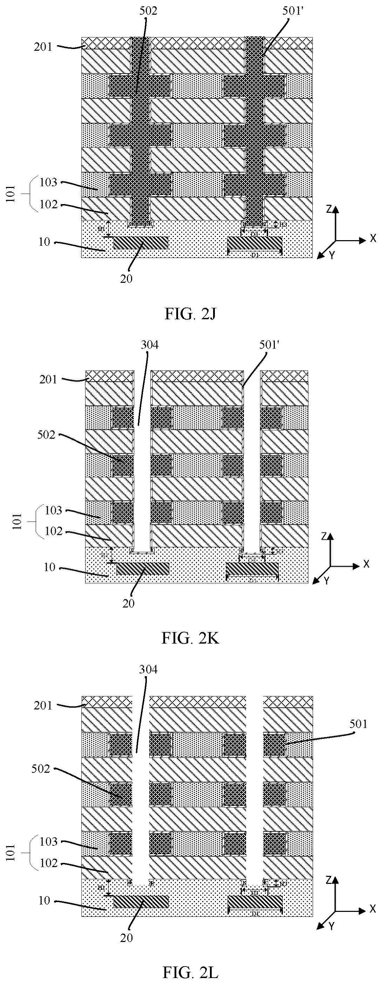

Referring to FIG. 1 and FIGS. 2I-2N, as shown in FIG. 2I, the stack opening 301, the second opening 302, and the second base substrate opening 402 together compose the third opening 303; a first conductive material layer 501' is formed in the third openings 303, and the first conductive material layer 501' covers the exposed surfaces of the third openings 303; as shown in FIG. 2J, a first sacrificial layer 502 is formed, and the first sacrificial layer 502 fills up the remaining part of the third openings 303; as shown in FIG. 2K, parts of the first sacrificial layer 502 are removed to form fourth openings 304, the remaining first sacrificial layer 502 is located only in the second openings 302, and the fourth openings 304 expose parts of the first conductive material layer 501', where as shown in FIG. 2K, the fourth openings 304 expose at least parts of the first conductive material layer 501' on side walls of the first layers 102; as shown in FIG. 2L, the first conductive material layer 501' exposed by the fourth openings 304 is removed; as shown in FIG. 2M, the process of removing the first conductive material layer 501' exposed by the fourth opening 304 further includes removing parts of the first conductive material layer 501' and parts of the first sacrificial layer 502 in the second base substrate openings 402 to prevent the generation of a leakage current due to the presence of the first conductive material layer 501' and the first sacrificial layer 502 in the second base substrate openings 402. As shown in FIG. 2N, the first sacrificial layer 502 in the second openings 302 is removed, and the remaining first conductive material layer 501' is used as a first conductive layer 501. The first conductive layer 501 covers only the exposed surfaces of the second openings 302; the stack opening 301, the base substrate opening 404, and the second opening 302 together compose a combined opening K2.

As shown in FIG. 2M, to completely remove the first conductive material layer 501' and the first sacrificial layer 502 in the second base substrate openings 402, the base substrate 10 may be over-etched, and thus the second base substrate opening 402 is further enlarged to form a third base substrate opening 403. The length of the third base substrate opening 403 along the first direction X is a fourth length D4; the fourth length D4 is greater than the third length D3, and the fourth length D4 is less than the first length D1. The depth of the third base substrate opening 403 along the third direction Z is a fourth spacing H4, and the fourth spacing H4 is greater than the third spacing H3. FIG. 2M only schematically shows that the fourth spacing H4 is less than the first spacing H1. It should be noted that, even if the fourth spacing H4 is equal to the first spacing H1, the performance of the base substrate 10 is not affected, because the isolation structure 20 can allow the over-etching of the base substrate 10 to stop at the top of the isolation structure 20; there is a large etching selectivity between the isolation structure 20 and the base substrate 10, such that the third base substrate opening 403, even if extending along the third direction, does not exceed the top of the isolation structure 20. If the isolation structure 20 is not provided, the third base substrate opening 403 may continue to extend along the third direction Z and the first direction X, and as a result, adjacent third base substrate openings become interconnected, which causes the semiconductor structure to fail and even causes the stacked structure at the top to crack and collapse, thus affecting the performance and yield of semiconductor structures.

As shown in FIG. 2N, the process of removing the first sacrificial layer 502 in the second openings 302 further includes: etching the third base substrate openings 403 to form base substrate openings 404. The base substrate opening 404 exposes the upper surface of the isolation structure 20, and the length of the base substrate opening 404 along the first direction X is a fifth length D5; the fifth length D5 is greater than the fourth length D4, and the fifth length D5 is less than the first length D1. The depth of the base substrate opening 404 along the third direction Z is a fifth spacing H5; the fifth spacing H5 is greater than the fourth spacing H4, and the fifth spacing H5 is equal to the first spacing H1. The isolation structure 20 allows the base substrate opening 404 to stop above the isolation structure 20, that is, the base substrate opening 404 exposes the upper surface of the isolation structure 20, which prevents the base substrate opening 404 from continuing to extend along the third direction Z, prevents adjacent substrate openings from becoming interconnected and the stacked structure from cracking and collapsing, and thereby improves the performance and yield of semiconductor structures.

As shown in FIGS. 2N-2P, the stack opening 301, the base substrate opening 404, and the second opening 302 together compose the combined opening K2. Forming capacitor structures 50 in combined openings K2 specifically includes: forming a first conductive layer 501 in the second openings 302, where the first conductive layer 501 covers only the exposed surfaces of the second openings 302; and forming a dielectric layer 502 on the first conductive layer 501, and forming a second conductive layer 505 on the dielectric layer 502, where the second conductive layer 505 includes a third conductive layer 503 and a fourth conductive layer 504, the second conductive layer 505 fills up the remaining parts of the combined openings K2, and the first conductive layer 501, the dielectric layer 502, and the second conductive layer 505 together compose the capacitor structures 50. The capacitor structures 50 extend along the first direction X and are disposed apart from each other in both the second direction Y and the third direction Z; the first conductive layer 501 and the third conductive layer 503 may be one or more of a metal (for example, tungsten, titanium, nickel, platinum, rhodium, ruthenium, aluminum, copper, molybdenum, iridium, silver, or gold), a metal alloy, a metal nitride, a metal silicide, and a metal carbide, for example, at least one of titanium nitride (TiN), tantalum nitride (TaN), tungsten nitride (WN), titanium aluminum nitride (TiAlN), iridium oxide (IrOx), and ruthenium oxide (RuOx). The fourth conductive layer 504 may be one or more of polycrystalline silicon or a conductively-doped semiconductor material, for example, conductively-doped silicon, conductively-doped germanium, conductively-doped silicon germanium, or the like. The dielectric layer 502 may be silicon oxide, silicon nitride, silicon oxynitride, or the like.

FIG. 3A to FIG. 3P are process flow diagrams showing a method for manufacturing a semiconductor structure provided according to another embodiment of the present disclosure.

Referring to FIG. 1 and FIGS. 3A-3B, a base substrate 10 is provided. Photoresist layers S 102 are formed on the base substrate 10, and first openings S 101 are provided between the photoresist layers S102. First processing is performed on the base substrate 10 through the first openings S101 to form second initial isolation structures 22' inside the base substrate 10, and then second processing is performed on the second initial isolation structures 22' to form isolation structures 20. A first spacing H1 is present between the top of the isolation structure 20 and the surface of the base substrate. A plurality of isolation structures 20 are disposed apart from each other, a first width M1 is present between adjacent isolation structures 20 along a first direction X. The first direction X refers to the direction in which the isolation structure 20 extends, and the first direction X is parallel to the surface of the base substrate 10. The first processing may be plasma implantation. The second initial isolation structures 22' having different depths may be obtained by controlling the energy of the plasma implantation, the second initial isolation structures 22' having different concentrations may be obtained by controlling the dose of the plasma implantation, and the second initial isolation structures 22' at different positions may be obtained by controlling the angle of the plasma implantation; the required second initial isolation structures 22' may be obtained by controlling the energy, dose, angle, and the like of the plasma implantation based on process requirements, and in an embodiment, the element for ion implantation may be oxygen atoms. The second processing may be high-temperature annealing. Specifically, in an embodiment, the element oxygen for the ion implantation reacts with a silicon base substrate through the high-temperature annealing to form the isolation structures 20, and the material of the isolation structures 20 may be silicon oxide. Silicon oxide is merely an example for description herein. The material of the isolation structures 20 may be silicon nitride, silicon oxynitride, or the like in other embodiments. The material of the base substrate may be silicon (Si), germanium (Ge), silicon germanium (GeSi), or silicon carbide (SiC), or may be silicon-on-insulator (SOI) or germanium-on-insulator (GOI), or may also be another material, for example, a group III-V compound, for example, gallium arsenide. The material of the base substrate in this embodiment is silicon.

Different from the previous embodiment, in this embodiment, the length of the isolation structure 20 along the first direction X is an original length D1', and the original length D1' is less than the first length D1; the first width M1 is present between adjacent isolation structures 20 along the first direction X, and the first width M1 is much greater than the original length D1'; the first spacing H1 is present between the surface of the base substrate and the top of the isolation structure 20, and a bottom spacing H1' is present between the surface of the base substrate and the bottom of the isolation structure 20.

FIGS. 3C-3D show another specific embodiment of forming the isolation structure 20. As shown in FIG. 3C, forming the isolation structures 20 inside the base substrate 10 specifically includes: etching the base substrate 10 to form first trenches 200' that are disposed apart from each other, and filling the first trenches 200' with an oxide to form the isolation structures 20. The top of the isolation structure 20 is flush with the base substrate 10, the length of the isolation structure 20 along the first direction X is an original length D1', and the original length D1' is less than the first length D1. The first width M1 is present between adjacent isolation structures 20 along the first direction X, and the first width M1 is much greater than the original length D1'. A bottom spacing H1' is present between the surface of the base substrate and the bottom of the isolation structure 20. The top of the isolation structure 20 may be flush with the upper surface of the base substrate 10 or a first spacing H1 may be present between the top of the isolation structure 20 and the upper surface of the base substrate 10. This is not limited here and selection may be made based on process requirements. In the following steps, an example in which the first spacing H1 is present between the top of the isolation structure 20 and the upper surface of the base substrate 10 is used.

Referring to FIG. 1 and FIG. 3E, a stacked structure 101 is formed on the base substrate 10, and the stacked structure 101 is formed by alternately stacking first layers 102 and second layers 103 in a third direction Z; the third direction Z is perpendicular to the surface of the base substrate. An etching barrier layer 201 and a hard mask layer 202 are provided on the stacked structure 101. The etching barrier layer 201 is located on the stacked structure 101, the hard mask layer 202 is located on the etching barrier layer 201, and the etching barrier layer 201 and the hard mask layer 202 provide protection when stack openings and base substrate openings are formed subsequently by etching to prevent the stacked structure 101 from being damaged.

Referring to FIG. 1 and FIGS. 3F-3G, stack openings 301 are formed. The stack openings 301 pass through the stacked structure 101 along the third direction Z and stop at the upper surface of the base substrate 10. Before the stack openings 301 are formed, the method further includes: forming the photoresist layers S102 on the stacked structure 101. Openings are provided between the photoresist layers S102, and the stacked structure 101 is etched through the openings to form the stack openings 301.

Referring to FIG. 1 and FIG. 3H, first base substrate openings 401 are formed. The first base substrate openings 401 are respectively located below the stack openings 301 and extend into the base substrate 10, and the lengths of the first base substrate opening 401 and the stack opening 301 along the first direction X are the same and are all the second length D2; the second length D2 is less than the first width M1, and the depth of the first base substrate opening 401's extending into the base substrate 10 is a second spacing H2. The stack opening 301 and the first base substrate opening 401 together compose a first opening K1, the orthographic projection of the first opening K1 on the base substrate 10 is located between adjacent isolation structure 20, that is, the second length D2 of the first opening K1 is less than the first width M1 between adjacent isolation structure 20. The orthographic projection of the first opening K1 on the base substrate 10 may be in the middle of adjacent isolation structures 20 or may deviate from the middle of adjacent isolation structures 20, and being in the middle means that the central axis of the first opening K1 and the central axis between adjacent isolation structure 20 coincide, while the orthographic projection of the first opening K1 relative to the isolation structure 20 cannot deviate to be beyond the first width M1 between adjacent isolation structures 20. The process of forming the first base substrate openings 401 further includes removing the hard mask layer 202 and the photoresist layers S102 at the top of the stacked structure 101. Allowing the first opening K1 to be disposed between adjacent isolation structures 20 can prevent electric leakage and a short circuit caused by over-etching of the base substrate 10 in a subsequent step.

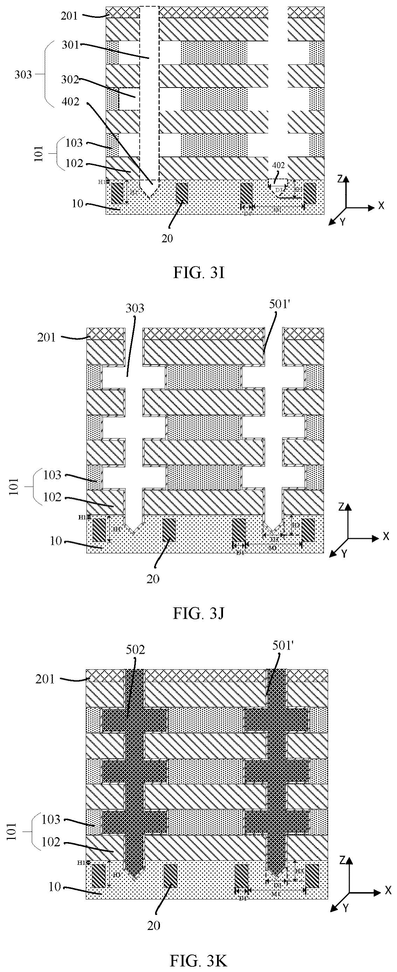

Referring to FIG. 1 and FIG. 3I, parts of the second layers 103 are removed to form second openings 302. The process of removing the parts of the second layers 103 by transverse etching to form the second openings 302 further includes etching the first base substrate openings 401 to form second base substrate openings 402. The length of the second base substrate opening 402 along the first direction X is a third length D3, the length of the first base substrate opening 401 along the first direction X is the second length D2, and the third length D3 may be greater than or equal to the second length D2; an example in which the third length D3 is equal to the second length D2 is used in this embodiment for description. The depth of the second base substrate opening 402's extending into the base substrate 10 along the third direction Z is a third spacing H3, the depth of the first base substrate opening 401's extending into the base substrate 10 along the third direction Z is the second spacing H2, and the third spacing H3 is greater than the second spacing H2. The first direction X is parallel to the surface of the base substrate 10, and the third direction Z is perpendicular to the surface of the base substrate 10. The stack opening 301, the second opening 302, and the second base substrate opening 402 together compose a third opening 303, and the base substrate 10 is over-etched in the process of forming the second openings 302 by transverse etching. The over-etching of the base substrate 10 may be in both a transverse direction and a longitudinal direction. To be specific, the base substrate 10 is over-etched not only along the first direction X but also along the third direction Z in the process of removing the parts of the second layers 103 by transverse etching to form the second openings 302. FIG. 3I shows only that a width D3 of the second base substrate opening 402 along the first direction does not expose the isolation structure 20, that is, the third length D3 is less than the first width M1, but in other embodiments, the width of the second base substrate opening 402 along the first direction may expose the isolation structure 20, that is, the third length D3 is equal to the first width M1. The isolation structure 20 can limit the over-etching of the base substrate 10, such that the over-etching of the base substrate 10 is limited between adjacent isolation structures 20, thus preventing the base substrate 10 from being further damaged in the transverse direction.

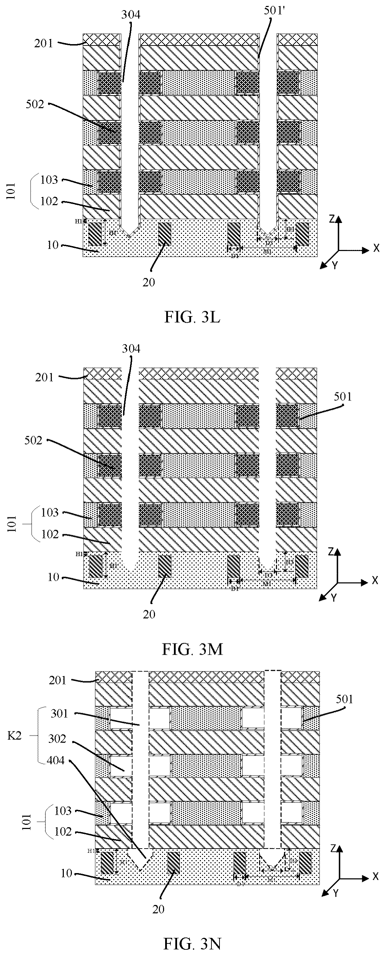

Referring to FIG. 1 and FIGS. 3J-3N, as shown in FIGS. 3I-3J, the stack opening 301, the second opening 302, and the second base substrate opening 402 together compose the third opening 303; a first conductive material layer 501' is formed in the third openings 303, and the first conductive material layer 501' covers the exposed surfaces of the third openings 303; as shown in FIG. 3K, a first sacrificial layer 502 is formed, and the first sacrificial layer 502 fills up the remaining parts of the third openings 303; as shown in FIG. 3L, parts of the first sacrificial layer 502 are removed to form fourth openings 304, the remaining first sacrificial layer 502 is located only in the second openings 302, and the fourth openings 304 expose parts of the first conductive material layer 501', where as shown in FIG. 3L, the fourth openings 304 expose at least the first conductive material layer 501' on side walls of the first layers 102 and surfaces of the second base substrate openings 402; as shown in FIG. 3M, the first conductive material layer 501' exposed by the fourth openings 304 is removed, and the remaining first conductive material layer 501' is used as a first conductive layer 501; as shown in FIG. 3N, after the first conductive material layer 501' exposed by the fourth openings 304 is removed, the method further includes: removing the first sacrificial layer 502 in the second openings 302. The base substrate 10 is further over-etched in the process of removing the first sacrificial layer 502 in the second openings 302, such that the second base substrate openings 402 are etched to form base substrate openings 404; the stack opening 301, the base substrate opening 404, and the second opening 302 together compose a combined opening K2. The length of the base substrate opening 404 along the first direction X is a fourth length D4, and the fourth length D4 is less than the first width M1. The depth of the base substrate opening 404 along the third direction Z is a fourth spacing H4, and the fourth spacing H4 is less than the bottom spacing H1'. FIG. 3N only schematically shows that the fourth length D4 is less than the first width M1. It should be noted that, even if the fourth length is equal to the first width M1, the performance of the base substrate 10 is not affected, because the isolation structure 20 can allow the over-etching of the base substrate 10 to stop between isolation structures 20; there is a large etching selectivity between the isolation structure 20 and the base substrate 10, such that the base substrate opening 404, even if further extending along the first direction, does not exceed the isolation structure 20. If the isolation structure 20 is not provided, the base substrate opening 404 may continue to extend along the first direction X, and as a result, adjacent base substrate openings become interconnected, which causes the semiconductor structure to fail and even causes the stacked structure at the top to crack and collapse, thus affecting the performance and yield of semiconductor structures.

Referring to FIG. 1 and FIGS. 3O-3P, the stack opening 301, the base substrate opening 404, and the second opening 302 together compose the combined opening K2. Forming capacitor structures 50 in combined openings K2 specifically includes: forming a first conductive layer 501 in the second openings 302, where the first conductive layer 501 covers only the exposed surfaces of the second openings 302; forming a dielectric layer 502 on the first conductive layer 501, and forming a second conductive layer 505 on the dielectric layer 502, where the second conductive layer 505 includes a third conductive layer 503 and a fourth conductive layer 504, the second conductive layer 505 fills up the remaining parts of the combined openings K2, and the first conductive layer 501, the dielectric layer 502, and the second conductive layer 505 together compose the capacitor structures 50. The capacitor structures 50 extend along the first direction X and are disposed apart from each other in both the second direction Y and the third direction Z; the first conductive layer 501 and the third conductive layer 503 may be one or more of a metal (for example, tungsten, titanium, nickel, platinum, rhodium, ruthenium, aluminum, copper, molybdenum, iridium, silver, or gold), a metal alloy, a metal nitride, a metal silicide, and a metal carbide, for example, at least one of titanium nitride (TiN), tantalum nitride (TaN), tungsten nitride (WN), titanium aluminum nitride (TiAlN), iridium oxide (IrOx), and ruthenium oxide (RuOx). The fourth conductive layer 504 may be one or more of polycrystalline silicon or a conductively-doped semiconductor material, for example, conductively-doped silicon, conductively-doped germanium, conductively-doped silicon germanium, or the like. The dielectric layer 502 may be silicon oxide, silicon nitride, silicon oxynitride, or the like.

FIG. 4A to FIG. 4O are process flow diagrams showing a method for manufacturing a semiconductor structure provided according to still another embodiment of the present disclosure.

Referring to FIG. 1 and FIGS. 4A-4C, a base substrate 10 is provided. Photoresist layers S102 are formed on the base substrate 10, first openings S101 are provided between the photoresist layers S102, and first processing is performed on the base substrate 10 through the first openings S101 to form first initial isolation structures 21' inside the base substrate 10; then, new photoresist layers S102 are formed, second openings S202 are provided between the photoresist layers S102, and first processing is performed on the base substrate 10 through the second openings S202 to form second initial isolation structures 22' inside the base substrate 10; second processing is performed on the first initial isolation structures 21' and the second initial isolation structures 22' to form first isolation structures 21 and second isolation structures 22, respectively, and the first isolation structure 21 and the second isolation structure 22 together compose the isolation structure 20; the first isolation structure 21 has a first width M1 along the first direction X, and a bottom spacing H1' is present between the upper surface of the first isolation structure 21 and the surface of the base substrate 10; a first spacing H1 is present between the top of the second isolation structure 22 and the surface of the base substrate 10, a bottom spacing H1' is present between the bottom of the second isolation structure 22 and the surface of the base substrate 10, and the length of the second isolation structure 22 along the first direction X is an original length D1'; the first isolation structures 21 are disposed apart from each other along the first direction X, and the second isolation structures 22 are also disposed apart from each other along the first direction X. The first processing may be plasma implantation. The first initial isolation structures 21' and the second initial isolation structures 22' having different depths may be obtained by controlling the energy of the plasma implantation, the first initial isolation structures 21' and the second initial isolation structures 22' having different concentrations may be obtained by controlling the dose of the plasma implantation, and the first initial isolation structures 21' and the second initial isolation structures 22' at different positions may be obtained by controlling the angle of the plasma implantation, the required first initial isolation structures 21' and second initial isolation structures 22' may be obtained by controlling the energy, dose, angle, and the like of the plasma implantation based on process requirements; in an embodiment, the element for ion implantation may be oxygen atoms. The second processing may be high-temperature annealing. Specifically, in an embodiment, the element oxygen for the ion implantation reacts with a silicon base substrate through the high-temperature annealing to form the first isolation structures 21 and the second isolation structures 22. The isolation structure 20 is composed of the first isolation structure 21 and the second isolation structure 22, and the material of the isolation structure 20 may be silicon oxide. Silicon oxide is merely an example for description herein. The material of the isolation structures 20 may be silicon nitride, silicon oxynitride, or the like in other embodiments. The material of the base substrate may be silicon (Si), germanium (Ge), silicon germanium (GeSi), or silicon carbide (SiC), or may be silicon-on-insulator (SOI) or germanium-on-insulator (GOI), or may also be another material, for example, a group III-V compound, for example, gallium arsenide. The material of the base substrate in this embodiment is silicon.

Different from other embodiments, in this embodiment, the isolation structure 20 is composed of the first isolation structure 21 and the second isolation structure 22, the first isolation structure 21 has a first width M1 along the first direction X, and a bottom spacing H1' is present between the upper surface of the first isolation structure 21 and the surface of the base substrate 10; a first spacing H1 is present between the top of the second isolation structure 22 and the surface of the base substrate 10, a bottom spacing H1' is present between the bottom of the second isolation structure 22 and the surface of the base substrate 10, and the length of the second isolation structure 22 along the first direction X is an original length D1'; the first isolation structures 21 are disposed apart from each other along the first direction X, and the second isolation structures 22 are also disposed apart from each other along the first direction X, and adjacent second isolation structures 22 and a nearest first isolation structure 21 form an encircling shape, such that in the process of forming base substrate openings subsequently, the isolation structure 20 can encircle the base substrate opening at the bottom and two sides to prevent the performance of the semiconductor structure from being affected by over-etching of the base substrate opening.

Referring to FIG. 1 and FIG. 4D, a stacked structure 101 is formed on the base substrate 10, and the stacked structure 101 is formed by alternately stacking first layers 102 and second layers 103 in a third direction Z; the third direction Z is perpendicular to the surface of the base substrate. An etching barrier layer 201 and a hard mask layer 202 are provided on the stacked structure 101. The etching barrier layer 201 is located on the stacked structure 101, the hard mask layer 202 is located on the etching barrier layer 201, and the etching barrier layer 201 and the hard mask layer 202 provide protection when stack openings and base substrate openings are formed subsequently by etching to prevent the stacked structure 101 from being damaged.

Referring to FIG. 1 and FIGS. 4E-4F, stack openings 301 are formed. The stack openings 301 pass through the stacked structure 101 along the third direction Z and stop at the upper surface of the base substrate 10. Before the stack openings 301 are formed, the method further includes: forming the photoresist layers S102 on the stacked structure 101. Openings are provided between the photoresist layers S102, and the stacked structure 101 is etched through the openings to form the stack openings 301.

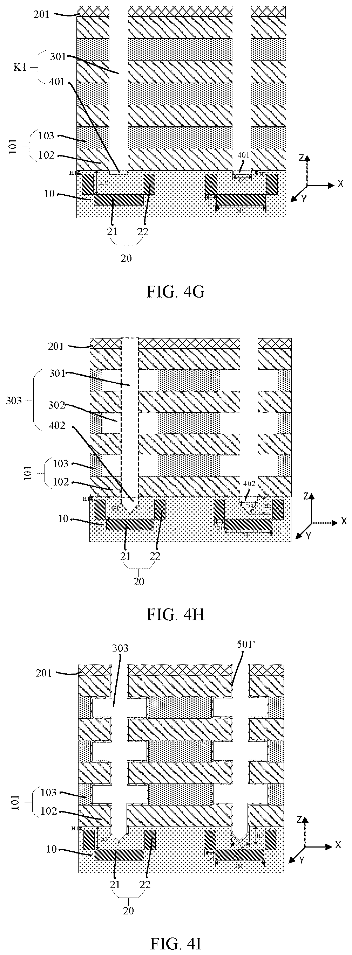

Referring to FIG. 1 and FIG. 4G, first base substrate openings 401 are formed. The first base substrate openings 401 are respectively located below the stack openings 301 and extend into the base substrate 10, and the lengths of the first base substrate opening 401 and the stack opening 301 along the first direction X are the same and are all the second length D2; the second length D2 is less than the first width M1, and the depth of the first base substrate opening 401's extending into the base substrate 10 is a second spacing H2. The stack opening 301 and the first base substrate opening 401 together compose a first opening K1, the orthographic projection of the first opening K1 on the base substrate 10 is located between adjacent isolation structure 20, that is, the second length D2 of the first opening K1 is less than the first width M1 between adjacent isolation structure 20. The orthographic projection of the first opening K1 on the base substrate 10 may be in the middle of adjacent isolation structures 20 or may deviate from the middle of adjacent isolation structures 20, and being in the middle means that the central axis of the first opening K1 and the central axis between adjacent isolation structure 20 coincide, while the orthographic projection of the first opening K1 relative to the isolation structure 20 cannot deviate to be beyond the first width M1 between adjacent isolation structures 20. The process of forming the first base substrate openings 401 further includes removing the hard mask layer 202 and the photoresist layers S102 at the top of the stacked structure 101. Allowing the first opening K1 to be disposed between adjacent isolation structures 20 can prevent electric leakage and a short circuit caused by over-etching of the base substrate 10 in a subsequent step.

Referring to FIG. 1 and FIG. 4H, parts of the second layers 103 are removed to form second openings 302. The process of removing the parts of the second layers 103 by transverse etching to form the second openings 302 further includes etching the first base substrate openings 401 to form second base substrate openings 402. The length of the second base substrate opening 402 along the first direction X is a third length D3, the length of the first base substrate opening 401 along the first direction X is the second length D2, and the third length D3 may be greater than or equal to the second length D2; an example in which the third length D3 is equal to the second length D2 is used in this embodiment for description. The depth of the second base substrate opening 402's extending into the base substrate 10 along the third direction Z is a third spacing H3, the depth of the first base substrate opening 401's extending into the base substrate 10 along the third direction Z is the second spacing H2, and the third spacing H3 is greater than the second spacing H2. The first direction X is parallel to the surface of the base substrate 10, and the third direction Z is perpendicular to the surface of the base substrate 10. The stack opening 301, the second opening 302, and the second base substrate opening 402 together compose a third opening 303, and the base substrate 10 is over-etched in the process of forming the second openings 302 by transverse etching. The over-etching of the base substrate 10 may be in both a transverse direction and a longitudinal direction. To be specific, the base substrate 10 is over-etched not only along the first direction X but also along the third direction Z in the process of removing the parts of the second layers 103 by transverse etching to form the second openings 302. FIG. 3I shows only that a width D3 of the second base substrate opening 402 along the first direction does not expose the isolation structure 20, that is, the third length D3 is less than the first width M1, but in other embodiments, the width of the second base substrate opening 402 along the first direction may expose the isolation structure 20, that is, the third length D3 is equal to the first width M1. The isolation structure 20 can limit the over-etching of the base substrate 10 in the transverse direction and limit the over-etching of the base substrate 10 in the longitudinal direction as well, such that the over-etching of the base substrate 10 is limited within isolation structures 20, thus preventing the base substrate 10 from being further damaged.

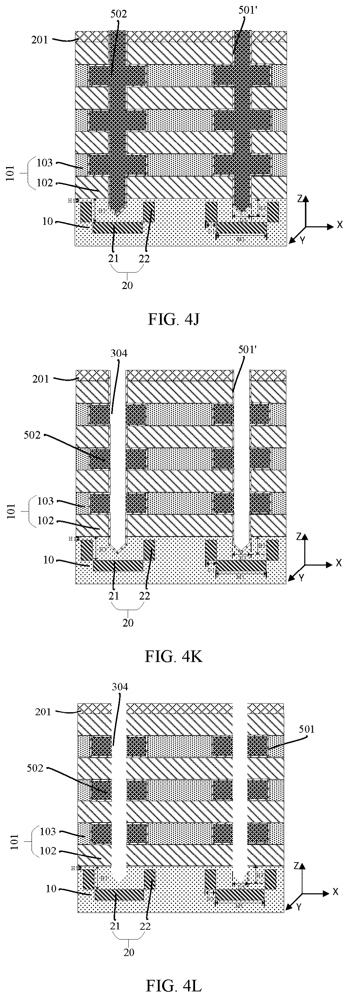

Referring to FIG. 1 and FIGS. 4I-4M, combined openings K2 are formed. As shown in FIGS. 4H-4I, the stack opening 301, the second opening 302, and the second base substrate opening 402 together compose the third opening 303; a first conductive material layer 501' is formed in the third openings 303, and the first conductive material layer 501' covers the exposed surfaces of the third openings 303; as shown in FIG. 4J, a first sacrificial layer 502 is formed, and the first sacrificial layer 502 fills up the remaining parts of the third openings 303; as shown in FIG. 4K, parts of the first sacrificial layer 502 are removed to form fourth openings 304, the remaining first sacrificial layer 502 is located only in the second openings 302, and the fourth openings 304 expose parts of the first conductive material layer 501', where as shown in FIG. 4K, the fourth openings 304 expose at least the first conductive material layer 501' on side walls of the first layers 102 and surfaces of the second base substrate openings 402; as shown in FIG. 4L, the first conductive material layer 501' exposed by the fourth openings 304 is removed, and the remaining first conductive material layer 501' is used as a first conductive layer 501; as shown in FIG. 4M, after the first conductive material layer 501' exposed by the fourth openings 304 is removed, the method further includes: removing the first sacrificial layer 502 in the second openings 302. The base substrate 10 is further over-etched in the process of removing the first sacrificial layer 502 in the second openings 302, such that the second base substrate openings 402 are etched to form base substrate openings 404; the stack opening 301, the base substrate opening 404, and the second opening 302 together compose a combined opening K2. The length of the base substrate opening 404 along the first direction X is a fourth length D4, and the fourth length D4 is less than the first width M1. The depth of the base substrate opening 404 along the third direction Z is a fourth spacing H4, and the fourth spacing H4 is less than the bottom spacing H1'. FIG. 4M only schematically shows that the fourth length D4 is less than the first width M1 and that the fourth spacing H4 is less than the bottom spacing H1'. It should be noted that, even if the fourth length is equal to the first width M1 and the fourth spacing H4 is equal to the bottom spacing H1', the performance of the base substrate 10 is not affected, because the first isolation structure 21 limits the over-etching of the base substrate 10 at the bottom, and the second isolations structure 22 limits the over-etching of the base substrate 10 on the sides, that is, the isolation structure 20 encircles the base substrate opening 404. The isolation structure 20 can allow the over-etching of the base substrate 10 to stop within the isolation structure 20; there is a large etching selectivity between the isolation structure 20 and the base substrate 10, such that the base substrate opening 404, even if further extending along the first direction and the third direction, does not exceed the isolation structure 20. If the isolation structure 20 is not provided, the base substrate opening 404 may continue to extend along the first direction X, and as a result, adjacent base substrate openings become interconnected, which causes the semiconductor structure to fail and even causes the stacked structure at the top to crack and collapse, thus affecting the performance and yield of semiconductor structures. The isolation structure 20 can prevent the cracking and collapsing of the stacked structure and improve the performance and yield of semiconductor structures.

Referring to FIG. 1 and FIGS. 4N-4O, the stack opening 301, the base substrate opening 404, and the second opening 302 together compose the combined opening K2. Forming capacitor structures 50 in combined openings K2 specifically includes: forming a first conductive layer 501 in the second openings 302, where the first conductive layer 501 covers only the exposed surfaces of the second openings 302; forming a dielectric layer 502 on the first conductive layer 501, and forming a second conductive layer 505 on the dielectric layer 502, where the second conductive layer 505 includes a third conductive layer 503 and a fourth conductive layer 504, the second conductive layer 505 fills up the remaining parts of the combined openings K2, and the first conductive layer 501, the dielectric layer 502, and the second conductive layer 505 together compose the capacitor structures 50. The capacitor structures 50 extend along the first direction X and are disposed apart from each other in both the second direction Y and the third direction Z; the first conductive layer 501 and the third conductive layer 503 may be one or more of a metal (for example, tungsten, titanium, nickel, platinum, rhodium, ruthenium, aluminum, copper, molybdenum, iridium, silver, or gold), a metal alloy, a metal nitride, a metal silicide, and a metal carbide, for example, at least one of titanium nitride (TiN), tantalum nitride (TaN), tungsten nitride (WN), titanium aluminum nitride (TiAlN), iridium oxide (IrOx), and ruthenium oxide (RuOx). The fourth conductive layer 504 may be one or more of polycrystalline silicon or a conductively-doped semiconductor material, for example, conductively-doped silicon, conductively-doped germanium, conductively-doped silicon germanium, or the like. The dielectric layer 502 may be silicon oxide, silicon nitride, silicon oxynitride, or the like.

FIG. 5 is a schematic diagram of a semiconductor structure provided according to an embodiment of the present disclosure.

Referring to FIG. 5, a semiconductor structure provided according to an embodiment of the present disclosure includes: a base substrate 10, where the base substrate 10 is provided inside with isolation structures 20, and the isolation structures 20 are disposed apart from each other; a stacked structure 101 disposed on the base substrate 10, where the stacked structure 101 is formed by alternately stacking first layers 102 and second layers 103 in a third direction Z, and the third direction Z is perpendicular to a surface of the base substrate 10; stack openings 301 represented in the figure using dotted lines, where the stack openings 301 pass through the stacked structure 101 along the third direction Z; and base substrate openings 404 represented in the figure using dotted lines, where the base substrate openings 404 are respectively below the stack openings 301 and extend into the base substrate 10. The size of the base substrate opening 404 along the first direction X is greater than the size of the stack opening 301 along the first direction X, the length of the base substrate opening 404 along the first direction X is a fifth length D5, the length of the isolation structure along the first direction X is a first length D1, and the fifth length D5 is less than the first length D1; an orthographic projection of the base substrate opening 404 on the base substrate 10 is located within an orthographic projection of the isolation structure 20 on the base substrate 10. The isolation structure 20 is located at the bottom of the base substrate opening 404, and the base substrate opening 404 exposes the upper surface of the isolation structure 20. A first spacing H1 is present between the top of the isolation structure 20 and the top of the base substrate 10. The second openings 302 are represented in the figure using dotted lines, and the second openings 302 are formed by removing parts of the second layers 103. The stack opening 301, the base substrate opening 404, and the second opening 302 together compose a combined opening K2. The capacitor structure 50 is located in the combined opening K2 and is located above the isolation structure, and the capacitor structures 50 extend along the first direction X and are disposed apart from each other in both the second direction Y and the third direction Z. The isolation structures 20 can prevent such problems as cracking and collapsing of the stacked structure 101 and electric leakage or a short circuit caused by over-etching of the base substrate 10, such that the performance and yield of semiconductor structures are improved.

FIG. 6 is a schematic diagram of a semiconductor structure provided according to another embodiment of the present disclosure.

Referring to FIG. 6, a semiconductor structure provided according to another embodiment of the present disclosure includes: a base substrate 10, where the base substrate 10 is provided inside with isolation structures 20, the isolation structures 20 are disposed apart from each other, the isolation structures 20 each have a width D1' along a first direction X, and a first width M1 is present between adjacent isolation structures 20 along the first direction X; a stacked structure 101 disposed on the base substrate 10, where the stacked structure 101 is formed by alternately stacking first layers 102 and second layers 103 in a third direction Z, and the third direction Z is perpendicular to a surface of the base substrate 10; stack openings 301 represented in the figure using dotted lines, where the stack openings 301 pass through the stacked structure 101 along the third direction Z; base substrate openings 404 represented in the figure using dotted lines, where the base substrate openings 404 are respectively below the stack openings 301 and extend into the base substrate 10. The size of the base substrate opening 404 along the first direction X is greater than the size of the stack opening 301 along the first direction X, the length of the base substrate opening 404 along the first direction X is a fourth length D4, the first width M1 is present between adjacent isolation structures 20 along the first direction X, and the fourth length D4 is less than the first width M1; an orthographic projection of the base substrate opening 404 on the base substrate 10 is located between adjacent isolation structures 20, that is, the isolation structures 20 are located on two sides of the base substrate opening 404. A first spacing H1 is present between the top of the isolation structure 20 and the top of the base substrate 10, a bottom spacing H1' is present between the surface of the base substrate and the bottom of the isolation structure 20, the depth of the base substrate opening 404 along the third direction Z is a fourth spacing H4, and the fourth spacing H4 is less than the bottom spacing H1'. The second openings 302 are represented in the figure using dotted lines, and the second openings 302 are formed by removing parts of the second layers 103. The stack opening 301, the base substrate opening 404, and the second opening 302 together compose a combined opening K2. The capacitor structure 50 is located in the combined opening K2, the capacitor structure 50 is located above the isolation structure 20, and the capacitor structures 50 extend along the first direction X and are disposed apart from each other in both the second direction Y and the third direction Z. The isolation structures 20 can prevent such problems as cracking and collapsing of the stacked structure and electric leakage or a short circuit caused by over-etching of the base substrate, such that the performance and yield of semiconductor structures are improved.

FIG. 7 is a schematic diagram of a semiconductor structure provided according to still another embodiment of the present disclosure.

Referring to FIG. 7, a semiconductor structure provided according to still another embodiment of the present disclosure includes a base substrate 10, and the base substrate 10 is provided inside with isolation structures 20. In this embodiment, the isolation structure 20 is composed of a first isolation structure 21 and a second isolation structure 22, the first isolation structure 21 has a first width M1 along the first direction X, and a bottom spacing H1' is present between the upper surface of the first isolation structure 21 and the surface of the base substrate 10; a first spacing H1 is present between the top of the second isolation structure 22 and the surface of the base substrate 10, a bottom spacing H1' is present between the bottom of the second isolation structure 22 and the surface of the base substrate 10, and the length of the second isolation structure 22 along the first direction X is an original length D1'; the first isolation structures 21 are disposed apart from each other along the first direction X, and the second isolation structures 22 are also disposed apart from each other along the first direction X. A stacked structure 101 is disposed on the base substrate 10, where the stacked structure 101 is formed by alternately stacking first layers 102 and second layers 103 in a third direction Z, and the third direction Z is perpendicular to a surface of the base substrate 10. stack openings 301 are represented in the figure using dotted lines, where the stack openings 301 pass through the stacked structure 101 along the third direction Z. Base substrate openings 404 are represented in the figure using dotted lines, where the base substrate openings 404 are respectively below the stack openings 301 and extend into the base substrate 10. The size of the base substrate opening 404 along the first direction X is greater than the size of the stack opening 301 along the first direction X, the length of the base substrate opening 404 along the first direction X is a fourth length D4, the first width M1 is present between adjacent isolation structures 20 along the first direction X, and the fourth length D4 is less than the first width M1; an orthographic projection of the base substrate opening 404 on the base substrate 10 is located between adjacent isolation structures 20, that is, the isolation structures 20 are located on two sides of the base substrate opening 404. A first spacing H1 is present between the top of the isolation structure 20 and the top of the base substrate 10, a bottom spacing H1' is present between the surface of the base substrate and the bottom of the isolation structure 20, the depth of the base substrate opening 404 along the third direction Z is a fourth spacing H4, and the fourth spacing H4 is less than the bottom spacing H1'. The second openings 302 are represented in the figure using dotted lines, and the second openings 302 are formed by removing parts of the second layers 103. The stack opening 301, the base substrate opening 404, and the second opening 302 together compose a combined opening K2. The capacitor structure 50 is located in the combined opening K2, the capacitor structure 50 is located above the isolation structure 20, and the capacitor structures 50 extend along the first direction X and are disposed apart from each other in both the second direction Y and the third direction Z. Adjacent second isolation structures 22 and a nearest first isolation structure 21 form an encircling shape, and the isolation structure 20 can encircle the base substrate opening 404 at the bottom and on two sides, thus preventing the performance of the semiconductor structure from being affected by over-etching of the base substrate opening 404. In other words, the isolation structures 20 can prevent such problems as cracking and collapsing of the stacked structure and electric leakage or a short circuit caused by over-etching of the base substrate, such that the performance and yield of semiconductor structures are improved.

Those of ordinary skill in the art can understand that the foregoing implementations are specific embodiments of practicing the present disclosure, while in practical application, various changes can be made to the implementations in form and detail without departing from the spirit and scope of the present disclosure. Any person skilled in the art can make various changes and modifications without departing from the spirit and scope of the present disclosure, and the protection scope of the present disclosure shall be defined by the appended claims.

## Claims

1. A method for manufacturing a semiconductor structure, comprising:
providing a base substrate (10) and forming isolation structures (20) inside the base substrate (10), wherein the isolation structures (20) are disposed apart from each other;
forming a stacked structure (101) on the base substrate (10), wherein the stacked structure (101) is formed by alternately stacking first layers (102) and second layers (103) in a third direction (Z), and the third direction (Z) is perpendicular to a surface of the base substrate (10);
forming stack openings (301), wherein the stack openings (301) pass through the stacked structure (101) along the third direction (Z);
forming first base substrate openings (401), wherein the first base substrate openings (401) are respectively located below the stack openings (301) and extend into the base substrate (10), one of the stack openings (301) and one of the first base substrate openings (401) compose one of first openings (K1), an orthographic projection of each of the first openings (K1) on the base substrate (10) is located within an orthographic projection of one of the isolation structures (20) on the base substrate (10), and/or the orthographic projection of the first opening (K1) on the base substrate (10) is located between adjacent isolation structures (20);
removing parts of the second layers (103) to form second openings (302), and etching the first base substrate openings (401) to form base substrate openings (404), wherein one of the stack openings (301), one of the base substrate openings (404), and some of the second openings (302) together compose one of combined openings (K2); and
forming capacitor structures (50) in the combined openings (K2), wherein the capacitor structures (50) extend along a first direction (X) and are disposed apart from each other in both a second direction (Y) and the third direction (Z).

2. The method for manufacturing a semiconductor structure according to claim 1, wherein the process of removing parts of the second layers (103) to form the second openings (302) further comprises: etching the first base substrate openings (401) to form second base substrate openings (402), wherein a size of each of the second base substrate openings (402) along the first direction (X) is greater than a size of each of the first base substrate openings (401) along the first direction (X); a depth of the second base substrate opening (402) along the third direction (Z) is greater than a depth of the first base substrate opening (401) along the third direction (Z), the first direction (X) is parallel to the surface of the base substrate (10), and the first direction (X) is perpendicular to the third direction (Z).

3. The method for manufacturing a semiconductor structure according to claim 2, wherein one of the stack openings (301), some of the second openings (302), and one of the second base substrate openings (402) together compose one of third openings (303), and the method further comprises: forming a first conductive material layer (501') in the third openings (303), wherein the first conductive material layer (501') covers exposed surfaces of the third openings (303); forming a first sacrificial layer (502), wherein the first sacrificial layer (502) fills up remaining parts of the third openings (303); removing parts of the first sacrificial layer (502) to form fourth openings (304), wherein remaining parts of the first sacrificial layer (502) are located only in the second openings (302); and removing parts of the first conductive material layer (501') exposed by the fourth openings (304), and removing the first sacrificial layer (502) in the second openings (302), wherein remaining parts of the first conductive material layer (501') are used as a first conductive layer (501).

4. The method for manufacturing a semiconductor structure according to claim 3, wherein the process of removing the parts of the first conductive material layer (501') exposed by the fourth openings (304) further comprises: etching the second base substrate openings (402) to form third base substrate openings (403), wherein a size of each of the third base substrate openings (403) along the first direction (X) is greater than a size of the second base substrate opening (402) along the first direction (X); a depth of the third base substrate opening (403) along the third direction (Z) is greater than a depth of the second base substrate opening (402) along the third direction (Z).

5. The method for manufacturing a semiconductor structure according to claim 4, wherein the process of removing the first sacrificial layer (502) in the second openings (302) further comprises: etching the third base substrate openings (403) to form the base substrate openings (404), wherein each of the base substrate openings (404) exposes an upper surface of one of the isolation structures (20), and/or the isolation structures (20) are respectively located on two sides of each of the base substrate openings (404).

6. The method for manufacturing a semiconductor structure according to claim 5, wherein one of the stack openings (301), one of the base substrate openings (404), and some of the second openings (302) together compose one of combined openings (K2), and forming the capacitor structures (50) in the combined openings (K2) specifically comprises: forming the first conductive layer (501) in the second openings (302), wherein the first conductive layer (501) covers only exposed surfaces of the second openings (302); and forming a dielectric layer (502) on the first conductive layer (501), and forming a second conductive layer (505) on the dielectric layer (502), wherein the second conductive layer (505) fills up remaining parts of the combined openings (K2), and the first conductive layer (501), the dielectric layer (502), and the second conductive layer (505) together compose the capacitor structures (50).

7. The method for manufacturing a semiconductor structure according to claim 6, wherein the isolation structures (20) are respectively located on two sides of the base substrate opening (404), a bottom spacing (H1') is present between a bottom of each of the isolation structures (20) and the surface of the base substrate (10) along the third direction (Z), and the base substrate opening (404) has a fourth spacing (H4) along the third direction (Z), wherein the fourth spacing (H4) is not greater than the bottom spacing (H1').

8. The method for manufacturing a semiconductor structure according to claim 1, wherein forming the isolation structures (20) inside the base substrate (10) specifically comprises: forming photoresist layers (S102) and defining first openings (S101), performing first processing through the first openings (S101) to form first initial isolation structures (21'), and performing second processing on the first initial isolation structures (21') to form the isolation structures (20), wherein a first spacing (H1) is present between a top of each of the isolation structures (20) and the surface of the base substrate (10).

9. The method for manufacturing a semiconductor structure according to claim 1, wherein forming the isolation structures (20) inside the base substrate (10) specifically comprises: etching the base substrate (10) to form first trenches (200'), wherein the first trenches (200') are disposed apart from each other; and forming the isolation structures (20) in the first trenches (200'), wherein tops of the isolation structures (20) are flush with the base substrate (10).

10. The method for manufacturing a semiconductor structure according to claim 1, wherein forming the isolation structures (20) inside the base substrate (10) specifically comprises: forming photoresist layers (S102) and defining first openings (S101), performing first processing through the first openings (S101) to form first initial isolation structures (21'), forming photoresist layers (S102) and defining second openings (S202), performing first processing through the second openings (S202) to form second initial isolation structures (22'), and performing second processing on the first initial isolation structures (21') and the second initial isolation structures (22') to form first isolation structures (21) and second isolation structures (22), respectively, wherein the first isolation structures (21) and the second isolation structures (22) compose the isolation structures (20), each of the first isolation structures (21) is located at a bottom of one of the first base substrate openings (401), and each of the second isolation structures (22) is located on a side of one of the first base substrate openings (401).

11. The method for manufacturing a semiconductor structure according to claim 1, wherein after the second openings (302) are formed, the method further comprises: removing parts of the first layers (102) to form first expanded holes (302'), wherein a size of each of the first expanded holes (302') along the third direction (Z) is greater than a size of each of the second openings (302) along the third direction (Z).

12. A semiconductor structure, comprising:
a base substrate (10), the base substrate (10) being provided inside with isolation structures (20), and the isolation structures (20) being disposed apart from each other;
a stacked structure (101) disposed on the base substrate (10), the stacked structure (101) being formed by alternately stacking first layers (102) and second layers (103) in a third direction (Z), and the third direction (Z) being perpendicular to a surface of the base substrate (10);
stack openings (301) passing through the stacked structure (101) along the third direction (Z);
base substrate openings (404) respectively located below the stack openings (301) and extending into the base substrate (10), a size of each of the base substrate openings (404) along the first direction (X) being greater than a size of each of the stack openings (301) along the first direction (X), and
each of the isolation structures (20) being located at least on a side of one of the base substrate openings (404) and/or each of the isolation structures (20) being located at least at a bottom of one of the base substrate openings (404);
second openings (302) formed by removing parts of the second layers (103), one of the stack openings (301), one of the base substrate openings (404), and some of the second openings (302) together composing one of combined openings (K2); and
capacitor structures (50) located in the combined openings (K2), the capacitor structures (50) extending along a first direction (X) and being disposed apart from each other in both a second direction (Y) and the third direction (Z).

13. The semiconductor structure according to claim 12, wherein the isolation structures (20) are respectively located on two sides of the base substrate opening (404), and an orthographic projection of the base substrate opening (404) on the base substrate (10) is located between adjacent isolation structures (20).

14. The semiconductor structure according to claim 12, wherein the isolation structure (20) is located at the bottom of the base substrate opening (404), and an orthographic projection of the base substrate opening (404) on the base substrate (10) is located within an orthographic projection of the isolation structure (20) on the base substrate (10).

15. The semiconductor structure according to claim 12, wherein the isolation structure (20) comprises a first isolation structure (21) and second isolation structures (22), the first isolation structure (21) is located at the bottom of the base substrate opening (404), and each of the second isolation structures (22) is located on a side of the base substrate opening (404).

16. The semiconductor structure according to claim 13, wherein a first spacing (H1) is present between a top of the isolation structure (20) and a top of the base substrate (10), or the top of the isolation structure (20) is flush with the top of the base substrate (10).

17. The semiconductor structure according to claim 16, wherein a bottom spacing (H1') is provided between a bottom of the isolation structure (20) and the surface of the base substrate (10) along the third direction (Z), and the base substrate opening (404) has a fourth spacing along the third direction (Z), wherein the fourth spacing is not greater than the bottom spacing (H1').

18. The semiconductor structure according to claim 14, wherein the base substrate opening (404) exposes the isolation structure (20), and each of the capacitor structures (50) is located above the isolation structure (20).
